(19) Europäisches Patentamt
European Patent Office
Office européen des brevets

(11) **EP 2 260 556 B1**

(12) **EUROPÄISCHE PATENTSCHRIFT**

(45) Veröffentlichungstag und Bekanntmachung des Hinweises auf die Patenterteilung:
**14.10.2015 Patentblatt 2015/42**

(21) Anmeldenummer: **08735072.4**

(22) Anmeldetag: **03.04.2008**

(51) Int Cl.:
*H02H 3/38* (2006.01)    *G01R 31/08* (2006.01)

(86) Internationale Anmeldenummer:
**PCT/EP2008/002752**

(87) Internationale Veröffentlichungsnummer:
**WO 2009/121382 (08.10.2009 Gazette 2009/41)**

(54) **VERFAHREN UND ANORDNUNG ZUM ERZEUGEN EINES FEHLERSIGNALS**

METHOD AND ARRANGEMENT FOR GENERATING AN ERROR SIGNAL

PROCÉDÉ ET DISPOSITIF DE PRODUCTION D'UN SIGNAL D'ERREUR

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**15.12.2010 Patentblatt 2010/50**

(73) Patentinhaber: **Siemens Aktiengesellschaft 80333 München (DE)**

(72) Erfinder: **JURISCH, Andreas 16727 Schwante (DE)**

(56) Entgegenhaltungen:
**EP-A- 0 933 643**

## Beschreibung

Die Erfindung bezieht sich auf eine Anordnung und ein Verfahren zum Erzeugen eines Fehlersignals, das den Ort eines Erdschlusses auf einer Leitung zwischen zwei Leitungsenden kennzeichnet, wobei bei dem Verfahren an beiden Leitungsenden jeweils die Spannung und der Strom unter Bildung von Messwerten gemessen und nach oder bei einer Detektion eines Erdschlusses der Ort des Erdschlusses ermittelt wird. Mit einem solchen Verfahren können beispielsweise Erdschlüsse in Netzen mit isoliertem Sternpunkt oder mit Resonanzsternpunkterdung erfasst und geortet werden.

Erdschlüsse in Netzen mit isoliertem Sternpunkt oder mit Resonanzsternpunkterdung führen zu einer Spannungsüberhöhung im gesamten über Transformatoren entkoppelten Teilnetz. Die Lokalisierung von Erdschlüssen bereitet immer wieder Schwierigkeiten und führt zu zeitaufwändigen Suchschaltungen, da die bis heute eingesetzten Verfahren zur Erdschlusserkennung nicht immer selektiv arbeiten.

Bisherige Verfahren setzen für die Erdschlussortung Geräte ein, die das Prinzip der Wattmetrischen Erdschlusserfassung, Oberschwingungsverfahren oder Erdschlusswischer-Relais nutzen.

Geräte nach dem Prinzip der Wattmetrischen Erdschlusserfassung bestimmen die komplexen Zeiger der Nullsystemgrößen von Strom und Spannung der Grundschwingung. Aus diesen Größen wird die Wirk- und Blindleistung der Nullsystemgrößen bestimmt. Der Wirkanteil dieses Signals zeigt die Richtung zum Erdschluss vom Relaiseinbauort aus gesehen an. Die ermittelten Richtungssignale müssen über eine Fernwirk- oder Leittechnik von den Geräten zu einer zentralen Auswertestelle transportiert werden. Dort kann mittels manueller oder programmgestützter Auswertung die vom Erdschluss betroffene Leitung ermittelt werden. Das Prinzip der Wattmetrischen Erdschlusserfassung setzt sehr genaue Wandler mit kleinen Winkelfehlern voraus. Üblicherweise müssen eingesetzte Kabelumbauwandler bei der Inbetriebnahme abgeglichen werden, um die hohen Genauigkeitsforderungen des Verfahrens zu erfüllen. Da die zu korrigierenden Winkelfehler der Wandler von der Aussteuerung der Wandler abhängig sind, ist dieser Abgleich fehleranfällig und kann zu unzuverlässigen Anzeigen führen.

Beim Prinzip des Erdschlusswischer-Relais sind folgende zwei Varianten bekannt: Bei der ersten Variante wird das Vorzeichen der ersten Halbschwingung des transienten Einschwingvorganges des Erdschlusses ausgewertet. Diese erste Variante funktioniert jedoch nur bei einem schlagartigen Erdschlusseintritt möglichst im Spannungsmaximum. Bei der zweiten Variante, auch qu-Verfahren genannt, wird aus den Augenblickswerten der Spannung und der Nullkapazität der zu untersuchenden Leitung der Verschiebestrom berechnet und mit dem gemessenen Nullstrom eine Lissajou-Figur gebildet. Der Anstieg dieser Kurve erlaubt eine Bestimmung der Erdschlussrichtung.

Beim Oberschwingungsverfahren werden künstlich über einen Transformatorsternpunkt Oberwellen eingeprägt und diese eingeprägten Oberwellen für die Erdschlussortung ausgenutzt. Wegen der aktiven Einspeisung der Oberwellen ist zusätzliche Primärtechnik im Netz notwendig. Das Verfahren gestattet ausschließlich die Bestimmung der Erdschlussrichtung.

Ferner ist aus der EP 0 933 643 A1 ein Verfahren zum Orten eines Fehlers in einem Drehstromnetz bekannt, bei dem unter Zuhilfenahme von an zwei Messstellen erfassten Nullsystemströmen und -spannungen ein fehlerbehafteter Knoten im Drehstromnetz ermittelt werden kann.

Der Erfindung liegt die Aufgabe zugrunde, ein zuverlässiges Verfahren zur Erdschlussortung anzugeben.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass mit den Messwerten der in der Nullspannung oder Nullstrom enthaltene Oberschwingungsanteil sowie dessen zeitliche Abklingkonstante für jedes der beiden Leitungsenden ermittelt wird, mit dem Oberschwingungsanteil und der Abklingkonstante für jedes Leitungsende jeweils eine Oberwellenzeigermessgröße nach Betrag und Phase gebildet wird, wobei sich der zeitliche Bezugspunkt der Phase der Oberwellenzeigermessgröße auf den Zeitpunkt der Erdschlussdetektion an dem jeweiligen Leitungsende bezieht, die in dieser Weise gebildeten Oberwellenzeigermessgrößen ausgehend von ihrem jeweiligen Leitungsende aus zeitlich in die Vergangenheit gedreht werden und ermittelt wird, zu welchem Zeitpunkt in der Vergangenheit und an welcher Stelle auf der Leitung die zurückgedrehten Oberwellenzeigermessgrößen zumindest annäherungsweise den gleichen Betrag und zumindest annäherungsweise die gleiche Phase aufweisen, und der in dieser Weise ermittelte Ort als Ort des Erdschlusses angesehen und mit dem Fehlersignal ausgegeben wird.

Ein wesentlicher Vorteil des erfindungsgemäßen Verfahrens ist darin zu sehen, dass bei diesem Oberwellen ausgewertet werden, wodurch eine sehr genaue Fehlerortung ermöglicht wird. Auch müssen nur geringe Anforderungen an die Messgenauigkeit der eingesetzten Wandler gestellt werden, da sich der Ort eines Erdschlusses bei dem erfindungsgemäßen Verfahren auch mit nicht speziell abgeglichenen Wandlern sehr genau ermitteln lässt.

Ein weiterer wesentlicher Vorteil des erfindungsgemäßen Verfahrens ist darin zu sehen, dass dieses Verfahren - im Unterschied zu den eingangs beschriebenen vorbekannten Verfahren-auch bei so genannten Erdschlusswischern zuverlässig arbeitet. Die Ortung der Erdschlusswischer funktioniert bei vorbekannten Verfahren nicht immer zuverlässig, da Erdschlusswischer nur transient vorhanden sind.

Ein dritter wesentlicher Vorteil des erfindungsgemäßen Verfahrens besteht darin, dass das Messen der Spannung an den beiden Leitungsenden synchronisationsfrei erfolgen kann und die Spannungsmesswerte an den beiden Leitungsenden unsynchronisiert sein können.

Gemäß einer bevorzugten Ausgestaltung des Verfahrens ist vorgesehen, dass unter Berücksichtigung der die Ausbreitung elektromagnetischer Wellen auf Leitungen beschreibenden Telegraphengleichung für einen wählbaren Ort auf der Leitung ein erster und ein zweiter Nullspannungszeiger für einen um die Ausbreitungszeit zum wählbaren Ort in der Vergangenheit liegenden Zeitpunkt unter Verwendung der Oberwellenzeigermeßgrößen von Nullstrom und Nullspannung an den beiden Leitungsenden berechnet werden, wobei der erste Nullspannungszeiger ausgehend von dem ersten Leitungsende in Richtung des zweiten Leitungsendes und der zweite Nullspannungszeiger ausgehend von dem zweiten Leitungsende in Richtung des ersten Leitungsendes berechnet wird, die in dieser Weise berechneten beiden Nullspannungszeiger miteinander verglichen werden und derjenige Ort ausgewählt wird, an dem die berechneten Nullspannungszeiger am besten übereinstimmen, und der in dieser Weise bestimmte Leitungsort als Ort des Erdschlusses angesehen wird. Mit der Telegraphengleichung ist eine Ortung sehr einfach und schnell möglich.

Gemäß einer weiteren bevorzugten Ausgestaltung des Verfahrens ist vorgesehen, dass die beiden Oberwellenzeigermessgrößen nach Betrag und Phase jeweils unter Zugrundelegung eines vorgegebenen Signalmodells, das den zeitlichen Verlauf der Nullspannung im Falle eines Erdschlusses nachbildet, mittels eines Schätzverfahrens bestimmt werden, wobei das vorgegebene Signalmodell zumindest die zu bestimmende Oberwellenzeigermessgröße mit einer festgelegten Zeigerkreisfrequenz, die ermittelte zeitliche Abklingkonstante des Oberschwingungsanteils und eine Nullspannungszeigermessgröße mit der Grundfrequenz der Nullspannung berücksichtigt und wobei im Rahmen des Schätzverfahrens der Betrag und die Phase der Oberwellenzeigermessgröße derart angepasst werden, dass die Abweichung zwischen dem zeitlichen Signalverlauf des nachgebildeten Signals des Signalsmodells und dem gemessenen zeitlichen Signalverlauf der Messwerte der Nullspannung minimal ist. Als Schätzverfahren wird bevorzugt ein Least-Squares-Schätzverfahren, ein Kalman-Filter-Algorithmus oder ein ARMAX-Schätzverfahren verwendet.

Im Übrigen wird es als vorteilhaft angesehen, wenn aus dem Frequenzspektrum des Oberschwingungsanteils eine für den Oberschwingungsanteil dominante Frequenz ausgewählt wird und die Zeigerkreisfrequenz der Oberwellenzeigermessgrößen jeweils derart festgelegt wird, dass sie der dominanten Frequenz entspricht. Beispielsweise kann in dem Oberschwingungsanteil diejenige Oberschwingungsfrequenz bestimmt werden, deren Amplitude maximal ist, und diese als Zeigerkreisfrequenz festgelegt werden.

Das Zeitfenster für die zur Bestimmung der Oberwellenzeigermessgrößen verwendeten Daten wird bevorzugt so bestimmt, dass der Zeitfensterbeginn auf den Beginn des Anstiegs der Nullspannung nach Überschreiten eines vorgegebenen Schwellenwertes festgelegt wird.

Der Oberschwingungsanteil wird bevorzugt ermittelt, indem nach der Detektion des Erdschlusses für jedes Leitungsende jeweils ein Messfenster geöffnet wird, für das mittels einer Fouriertransformation das Frequenzspektrum der Nullspannung ermittelt wird, und das Frequenzspektrum einer Hochpassfilterung unterzogen wird, bei der die Oberwellen von der Grundfrequenz der Nullspannung unter Bildung des Oberschwingungsanteils getrennt werden.

Die Abklingkonstante lässt sich besonders einfach und damit vorteilhaft ermitteln, indem der Effektivwert des Oberschwingungsanteils bestimmt wird und die zeitliche Abklingkonstante des Effektivwertes ermittelt wird und die ermittelte zeitliche Abklingkonstante des Effektivwertes als zeitliche Abklingkonstante des Oberschwingungsanteils angesehen wird.

Um einen möglichst geringen Apparateaufwand zu erreichen, wird es als vorteilhaft angesehen, wenn bei dem Verfahren das Messen von Spannung und Strom an den beiden Leitungsenden synchronisationsfrei erfolgt und die Spannungs- und Strommesswerte an den beiden Leitungsenden unsynchronisiert sind.

Die Erfindung bezieht sich außerdem auf eine Anordnung zum Erzeugen eines Fehlersignals, das den Ort eines Erdschlusses auf einer Leitung zwischen einem ersten und einem zweiten Leitungsende kennzeichnet, wobei die Anordnung aufweist: ein erstes Messgerät an dem ersten Leitungsende der Leitung und ein zweites Messgerät an dem zweiten Leitungsende der Leitung.

Erfindungsgemäß ist eine mit den beiden Messgeräten verbundene Auswerteinrichtung vorhanden, die geeignet ist, mit den Messwerten der beiden Messgeräte ein Verfahren auszuführen, wie es oben beschrieben ist.

Die Auswerteinrichtung kann beispielsweise durch eine programmierte Datenverarbeitungsanlage gebildet sein.

Die Auswerteinrichtung kann in einer Zentraleinrichtung angeordnet sein, mit der die beiden Messgeräte in Verbindung stehen. Alternativ können die beiden Messgeräte miteinander verbunden sein, wobei die Auswerteinrichtung in einem der Messgeräte implementiert ist.

Die Erfindung bezieht sich außerdem auf ein Feldgerät, insbesondere Schutzgerät, zum Anschluss an ein Leitungsende einer elektrischen Leitung und zum Erkennen eines Erdschlusses auf der Leitung. Erfindungsgemäß weist das Feldgerät auf: eine Auswerteinrichtung, die geeignet ist, ein Verfahren wie oben beschrieben auszuführen, sowie einen Datenanschluss zum Anschluss an ein anderes Messgerät zum Empfangen von Messwerten, die sich auf das andere Leitungsende der Leitung beziehen.

Die Erfindung wird nachfolgend anhand von Ausführungsbeispielen näher erläutert; dabei zeigen beispielhaft:

Figur 1          eine Anordnung mit drei Feldgeräten,

Figur 2          das elektrische Ersatzschaltbild der Anordnung gemäß Figur 1,

Figuren 3, 4     vereinfachte elektrische Ersatzschaltbilder der Anordnung gemäß Figur 1,

Figur 5          ein elektrisches Ersatzschaltbild einer erdschlussbehafteten Energieübertragungsleitung,

Figur 6          einen typischen Verlauf der Nullgrößen bei einem Erdschluss,

Figur 7          Signalverarbeitungsschritte zur Datenfenster- und Zeitkonstantenbestimmung,

Figur 8          Spektren von Nullstrom und Nullspannung,

Figur 9          die Übereinstimmung von gemessenen und geschätzten Signalen (komplettes Datenfenster),

Figur 10         die Übereinstimmung von gemessenen und geschätzten Signalen (Ausschnitt),

Figur 11         berechnete komplexe Zeiger,

Figur 12         den Verlauf einer Kostenfunktion,

Figur 13         schematisch die Ausbreitung einer Welle auf einer Leitung und

Figur 14         ein Ausführungsbeispiel für ein erfindungsgemäßes Feldgerät.

In den Figuren werden der Übersicht halber für identische oder vergleichbare Komponenten stets dieselben Bezugszeichen verwendet.

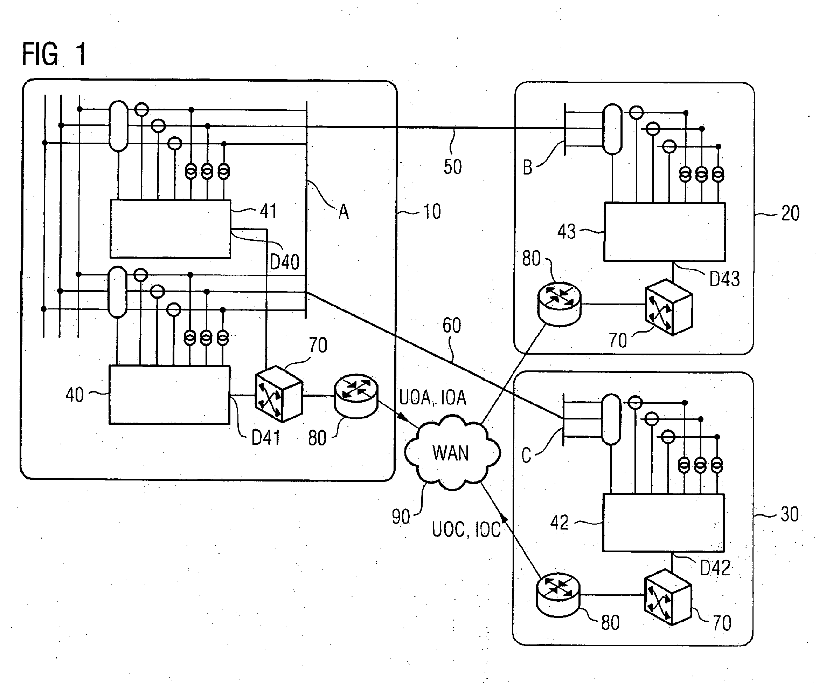

In der Figur 1 ist eine elektrische Anordnung dargestellt, die drei Umspannwerke 10, 20 und 30 umfasst. In dem Umspannwerk 10 sind zwei Feldgeräte 40 und 41 enthalten, in den beiden Umspannwerken 20 und 30 je eines. Die vier Feldgeräte 40, 41, 42 und 43 können beispielsweise baugleich sein, jedoch ist dies nicht zwingend.

Die Anschlussstelle A des Umspannwerkes 10 und die Anschlussstelle B des Umspannwerkes 20 sind miteinander durch eine beispielsweise dreiphasige Energieübertragungsleitung 50 verbunden; die Anschlussstelle A des Umspannwerkes 10 und die Anschlussstelle C des Umspannwerkes 30 sind miteinander durch eine beispielsweise dreiphasige Energieübertragungsleitung 60 verbunden.

Die Feldgeräte stehen über ihren Datenanschluss D40, D41, D42 und D43 mit lokalen Netzen 70, Routern 80 sowie einem WAN 90 (WAN: wide area network), wie beispielsweise dem Internet, und damit auch miteinander in einer Datenverbindung, zum Beispiel nach dem ETHERNET-Standard unter Verwendung fest vorgegebener IP-Adressen für jedes der Feldgeräte.

Über diese Datenverbindung kann beispielsweise das Feldgerät 40 des Umspannwerkes 10 mit dem Feldgerät 42 des Umspannwerkes 30 Daten austauschen, beispielsweise jeweils die Messwerte von Strom und Spannung an den jeweiligen Anschlussstellen A und C und/oder daraus abgeleitete Messwerte, wie beispielsweise Oberwellenzeigermessgrößen nach Betrag und Phase. So können beispielsweise Oberwellenzeigermessgrößen U0A und I0A von dem Feldgerät 40 zu dem Feldgerät 42 und Oberwellenzeigermessgrößen U0C und I0C von dem Feldgerät 42 zu dem Feldgerät 40 übertragen werden.

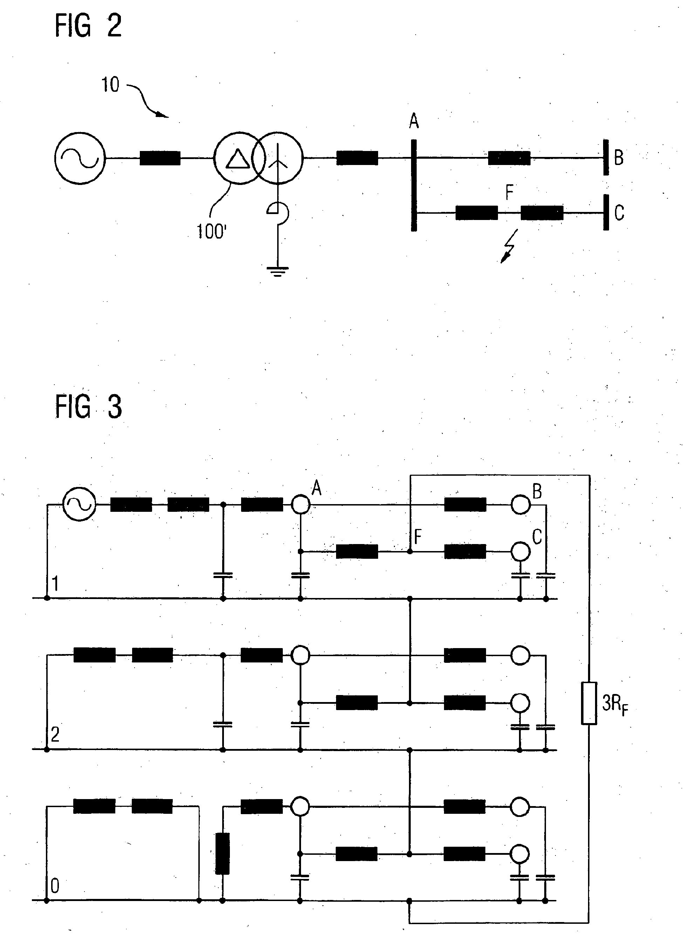

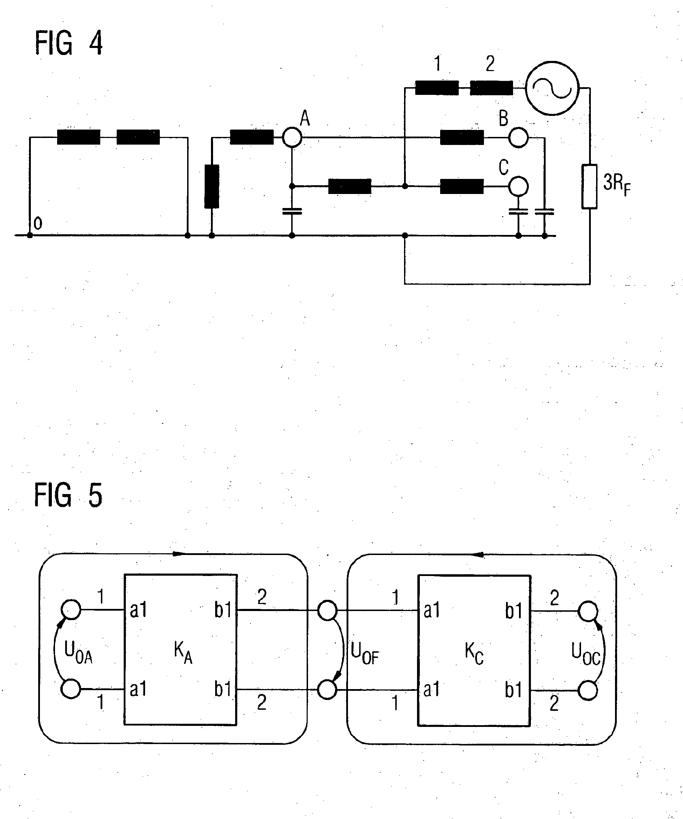

Das vereinfachte elektrische Ersatzschaltbild der Anordnung gemäß der Figur 1 zeigen beispielhaft die Figuren 2 und 3. Man erkennt, dass das Teilnetz rechts eines Transformators 100 des Umspannwerks 10 mit einer Resonanzsternpunkterdung versehen ist. Wird in diesem Teilnetz für das Mit- und Gegensystem ein Ersatzwiderstand und eine Ersatzspannungsquelle gebildet, entsteht ein vereinfachtes Ersatzschaltbild, das in der Figur 4 gezeigt ist.

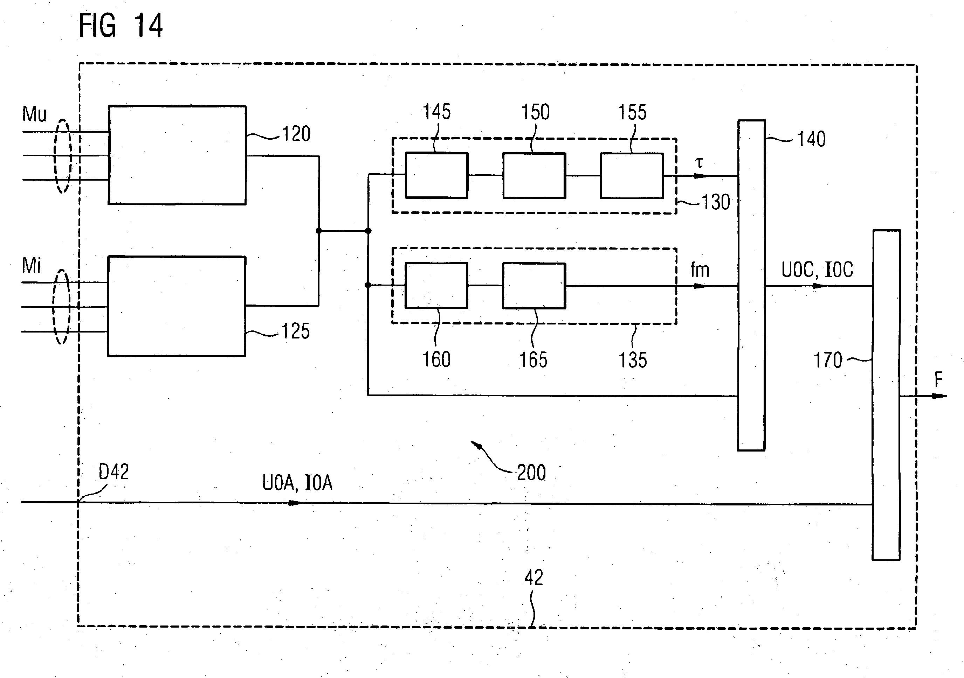

In der Figur 14 ist ein Ausführungsbeispiel für das Feldgerät 42 gezeigt. Die Feldgeräte 40, 41 und 43 aus Figur 1 können identisch oder ähnlich aufgebaut sein.

Man erkennt in der Figur 14 einen Nullspannungsbildner 120 sowie einen Nullstrombildner 125, die eingangsseitig an die Anschlussstelle C des Umspannwerkes 30 angeschlossen sind und Strommesswerte Mi und Spannungsmesswerte Mu erhalten. Dem Nullspannungsbildner 120 und dem Nullstrombildner 125 nachgeordnet sind eine Einrichtung 130 zum Bestimmen einer Abklingkonstante $\tau$, eine Einrichtung 135 zum Festlegen einer Oberschwingungsfrequenz fm sowie eine Schätzeinrichtung 140.

Die Einrichtung 130 zum Bestimmen der Abklingkonstante $\tau$ umfasst einen Hochpass 145, einen Effektivwertbildner 150 sowie einen Zeitkonstantenbestimmer 155.

Die Einrichtung 135 zum Festlegen der Oberschwingungsfrequenz fm umfasst eine FFT-Einrichtung (FFT: Fast Fourier Transformation) 160 sowie einen Maximalwertsucher 165.

Die Ausgänge der Einrichtungen 130 und 135 sind an weitere Eingänge der Schätzeinrichtung 140 angeschlossen. Ausgangsseitig steht die Schätzeinrichtung 140 mit einer Fehlerortbestimmeinrichtung 170 in Verbindung, die eingangsseitig außerdem an den Datenanschluss D42 angeschlossen ist.

Das Feldgerät 42 kann beispielsweise wie folgt betrieben werden:

Zunächst bilden der Nullspannungsbildner 120 sowie der Nullstrombildner 125 Nullspannungswerte und Nullstromwerte.

Die Einrichtung 130 zum Bestimmen der Abklingkonstante filtert mit ihrem Hochpass 145 aus der Nullspannung den Oberschwingungsanteil heraus und bildet mit dem Effektivwertbildner 150 einen Effektivwert des Oberschwingungsanteils. Mit dem Zeitverlauf des Effektivwerts des Oberschwingungsanteils ermittelt der Zeitkonstantenbestimmer 155 den zeitlichen Abfall des Effektivwerts unter Bildung der Abklingkonstante $\tau$, die zu der Schätzeinrichtung 140 gelangt.

Der Maximalwertsucher 165 der Einrichtung 135 sucht in dem von der FFT-Einrichtung 160 gebildeten Spannungsfrequenzspektrum eine dominierende Frequenz fm heraus und leitet diese zu der Schätzeinrichtung 140. Beispielsweise wird der Maximalwertsucher 165 in dem Oberschwingungsanteil diejenige Oberschwingungsfrequenz bestimmen, deren Amplitude maximal ist, und diese Frequenz als dominierende Frequenz fm ausgeben.

In der Schätzeinrichtung 140 ist ein Signalmodell hinterlegt, das den zeitlichen Verlauf der Nullspannung im Falle eines Erdschlusses nachbildet. Das Signalmodell berücksichtigt als den Signalverlauf bestimmende Einflussparameter eine Oberwellenzeigermessgröße mit der dominierende Frequenz fm, die Abklingkonstante $\tau$ und eine Nullspannungszeigermessgröße mit der Grundfrequenz der Nullspannung. Nach einem vorgegebenen Schätzverfahren passt die Schätzeinrichtung 140 unter Heranziehung dieses Signalmodells den Betrag und die Phase der Oberwellenzeigermessgröße derart bzw. solange an, bis die Abweichung zwischen dem zeitlichen Signalverlauf des nachgebildeten Signals des Signalsmodells und dem gemessenen zeitlichen Signalverlauf der Messwerte der Nullspannung minimal ist. In dieser Weise wird ausgangsseitig mit dem Oberschwingungsanteil und der Abklingkonstante $\tau$ eine Oberwellenzeigermessgröße nach Betrag und Phase für die Spannung und in entsprechender Weise für den Strom gebildet, wobei sich der zeitliche Bezugspunkt der Phase der Oberwellenzeigermessgröße auf den Zeitpunkt der Erdschlussdetektion an dem jeweiligen Leitungsende bezieht. Die Oberwellenzeigermessgrößen für Strom und Spannung sind mit den Bezugszeichen U0C und I0C gekennzeichnet.

Die Oberwellenzeigermessgrößen U0C und I0C sowie die Oberwellenzeigermessgrößen U0A und I0A gelangen zu der Fehlerortbestimmeinrichtung 170, die die in der beschriebenen Weise gebildeten Oberwellenzeigermessgrößen mathematisch ausgehend von ihrem jeweiligen Leitungsende A bzw. C aus zeitlich in die Vergangenheit dreht und ermittelt, zu welchem Zeitpunkt in der Vergangenheit und an welcher Stelle auf der Leitung 60 die beiden zurückgedrehten Oberwellenzeigermessgrößen U0C und U0A sowie die beiden zurückgedrehten Oberwellenzeigermessgrößen I0A und I0C zumindest annäherungsweise den gleichen Betrag und zumindest annäherungsweise die gleiche Phase aufweisen. Der in dieser Weise ermittelte Ort wird als Ort des Erdschlusses angesehen und mit dem Fehlersignal F ausgegeben.

Das mathematische Zurückdrehen der Oberwellenzeigermessgrößen kann beispielsweise unter Berücksichtigung der die Ausbreitung elektromagnetischer Wellen auf Leitungen beschreibenden Telegraphengleichung erfolgen. Hierbei wird für einen wählbaren Ort der Betrag und die Phase der Oberwellenzeigermessgröße der Nullspannung für einen um die Ausbreitungszeit zum wählbaren Ort in der Vergangenheit liegenden Zeitpunkt aus den Oberwellenzeigermeßgrößen von Nullstrom und Nullspannung des jeweils eigenen Leitungsendes in Richtung des anderen Leitungsendes berechnet. Die in dieser Weise berechneten Zeiger der Nullspannung - ausgehend von jedem der beiden Leiterenden - werden miteinander verglichen und es wird derjenige Ort ausgewählt, an dem die berechneten Zeiger am besten übereinstimmen.

Die Komponenten 120, 125, 130, 135, 140 und 170 des Feldgeräts 42 bilden eine Auswerteinrichtung 200; diese kann beispielsweise durch eine Datenverarbeitungsanlage gebildet sein.

Die oben beschriebene Vorgehensweise zum Bestimmen des Fehlerorts kann beispielsweise im Detail wie folgt aussehen:

Wenn davon ausgegangen wird, dass die Messwerte von Nullsystemspannung und Nullsystemstrom für die Netzknoten A und C zur Verfügung stehen, kann für eine fehlerbehaftete Leitung ein Ersatzschaltbild des Nullsystems aufgestellt werden, wie es in der Figur 5 dargestellt ist.

In der Figur 5 sind zwei Maschen zu erkennen, die an der Fehlerstelle F eine gemeinsame Spannung für die Spannung im Nullsystem an der Fehlerstelle U0F enthalten. Die beiden Vierpole KA und KC repräsentieren das Leitungsmodell des Nullsystems von den Leitungsenden der Knoten A bzw. C bis zur Fehlerstelle F. Die folgende Gleichung zeigt die Kettenmatrix für die Vierpole:

$$\begin{pmatrix} U_2 \\ I_2 \end{pmatrix} = \begin{pmatrix} k_{11} & k_{12} \\ k_{21} & k_{22} \end{pmatrix} \cdot \begin{pmatrix} U_1 \\ I_1 \end{pmatrix}$$

*mit* :

$$K = \begin{pmatrix} \cosh(\gamma(j\omega)\cdot l) & Z_W(j\omega)\cdot\sinh(\gamma(j\omega)\cdot l) \\ \dfrac{1}{Z_W(j\omega)}\cdot\sinh(\gamma(j\omega)\cdot l) & \cosh(\gamma(j\omega)\cdot l) \end{pmatrix}$$

*und* :

$$Z_W(j\omega) = \sqrt{\dfrac{R' + i\omega\cdot L'}{G' + i\omega\cdot C'}}$$

$$\gamma(j\omega) = \sqrt{(R' + i\omega\cdot L')\cdot(G' + i\omega\cdot C')}$$

Die Größen R', L',G' und C' stellen die kilometrischen Größen von Serienresistanz, Serieninduktivität, Parallelleitwert und Parallelkapazität der Leitung dar. Für die Fehlerstelle lassen sich nun folgende beiden Gleichungen aufstellen:

$$U_{0rA} = U_{0rC} = U_{0F}$$

*mit*

$$U_{0F} = U_{0rA} = k_{11}(j\omega, l)\cdot U_{0A} + k_{12}(j\omega, l)\cdot I_{0A}$$

$$U_{0F} = U_{0rC} = k_{11}(j\omega, 1-l)\cdot U_{0C} + k_{12}(j\omega, 1-l)\cdot I_{0C}$$

Die Funktionen k in Abhängigkeit der Frequenz für eine gegebene Leitungslänge können als bekannt vorausgesetzt werden. Damit bleibt für das oben aufgestellte Gleichungssystem nur die Fehlerentfernung l als unbekannte Größe. Diese Größe kann durch direkte Lösung der angegebenen Gleichung ermittelt werden, wenn die komplexen Zeiger für U0A, I0A, U0C und I0C vorliegen.

Durch Aufstellung einer Kostenfunktion kann die oben dargestellte Funktion in ein nichtlineares Optimierungsproblem umgewandelt werden. In diesem Fall können zusätzlich die Parameter der kilometrischen Impedanzen in den Vektor der zu optimierenden Größen aufgenommen werden. Als Kostenfunktion kann der Quadratische Modellfehler der Spannung am Fehlerort verwendet werden:

$$e(l, j\omega, R', L', G', C') = \left(\operatorname{Re}\{U_{0rA}\} - \operatorname{Re}\{U_{0rC}\}\right)^2 + \left(\operatorname{Im}\{U_{0rA}\} - \operatorname{Im}\{U_{0rC}\}\right)^2$$

*mit*

$$U_{0rA} = k_{11}(j\omega,l) \cdot U_{0A} + k_{12}(j\omega,l) \cdot I_{0A}$$

$$U_{0rC} = k_{11}(j\omega,1-l) \cdot U_{0C} + k_{12}(j\omega,1-l) \cdot I_{0C}$$

Durch Anwendung eines z.B. aus der Schrift "A Fast Algorithm For Fast Nonlinearly Constrained Optimization Calculations" (Powell, M.J.D., Numerical Analysis, G.A. Watson ed., Lecture Notes in Mathematics, Springer Verlag, Vol. 630, 1978) bekannten nichtlinearen Optimierungsverfahrens wird die folgende Optimierungsaufgabe gelöst:

$$\min_l \quad e(l, j\omega, R', L', G', C')$$

mit

$$l \in [0\ 1]$$

Für die komplexen Zeiger U0A, I0A, U0C und I0C werden dabei nicht die Zeiger der Grundwelle, sondern Zeiger für die dominante Einschwingfrequenz verwendet. Diese können beispielsweise wie folgt bestimmt werden: Im Nullsystem entsteht aus der Reaktanz der im Sternpunkt des Einspeisetransformators befindlichen Petersen-Spule und der Kapazität des Gesamtnetzes gegen Erde ein Parallelschwingkreis, der auf die Netzfrequenz abgestimmt ist. Dieses Signal liefert bei einem guten Abgleich einen korrelierten Anteil zum Grundwellenzeiger und kann damit erhebliche Messfehler bei der Zeigerbestimmung hervorrufen. Die Längsinduktivitäten des Netzes bilden jedoch mit den Erdkapazitäten der Leitung weitere Serien- und Parallelresonanzkreise, die bei Erdschlusseintritt durch das Entladen des vom Erdschluss betroffenen Leiters und dem Aufladen der nicht betroffenen Leiter zu Einschwingvorgängen auf ihrer Eigenfrequenz angeregt werden.

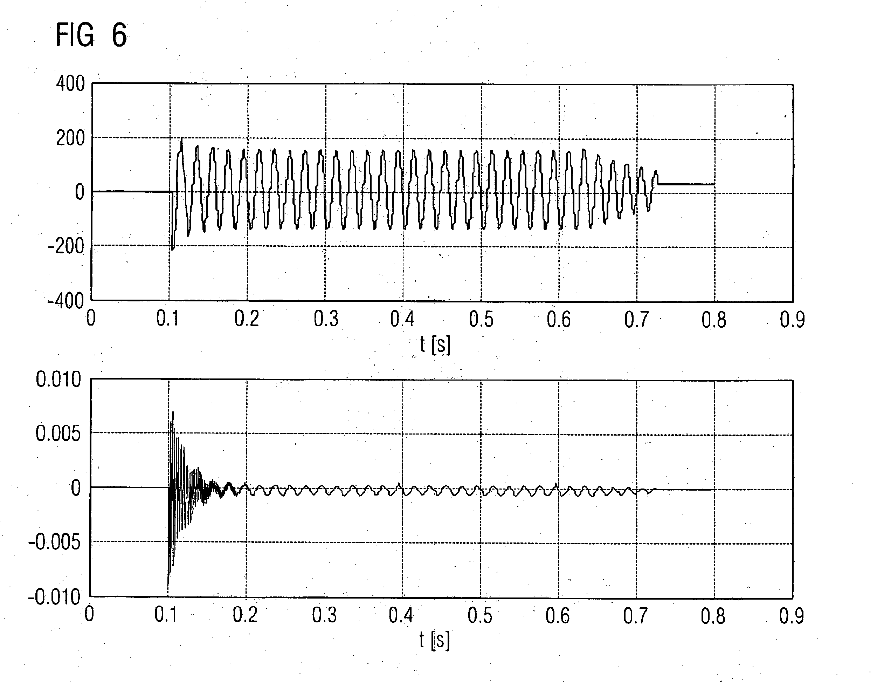

Die Figur 6 zeigt einen typischen Verlauf von Nullstrom und -spannung bei einem Erdschlusseintritt. In der Figur 6 ist deutlich der Einschwingvorgang der Nullspannung (oberes Diagramm) und des Nullstroms (unteres Diagramm) zu erkennen. Hier ist ersichtlich, dass die Amplitude des Nullstroms während des Einschwingvorganges ein Mehrfaches der Stromamplitude während des eingeschwungenen Zustands beträgt.

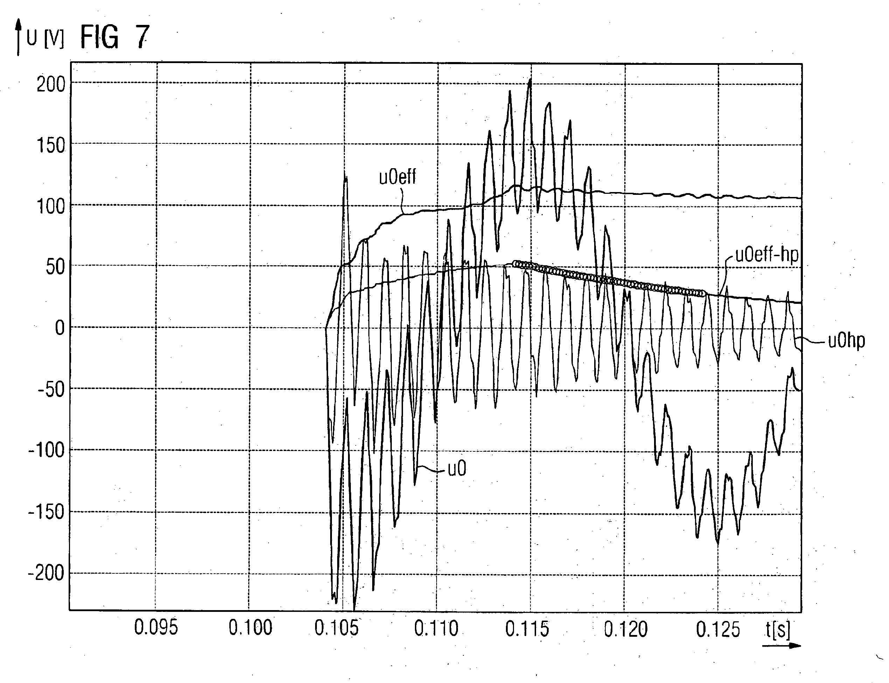

Die Figur 7 zeigt einen Ausschnitt des Einschwingvorgangs der Spannung; dabei bezeichnen u0 die gemessene Nullspannung, u0eff den Effektivwert der Nullspannung, u0hp die hochpassgefilterte Nullspannung und u0eff-hp den hochpassgefilterten Effektivwert der Nullspannung.

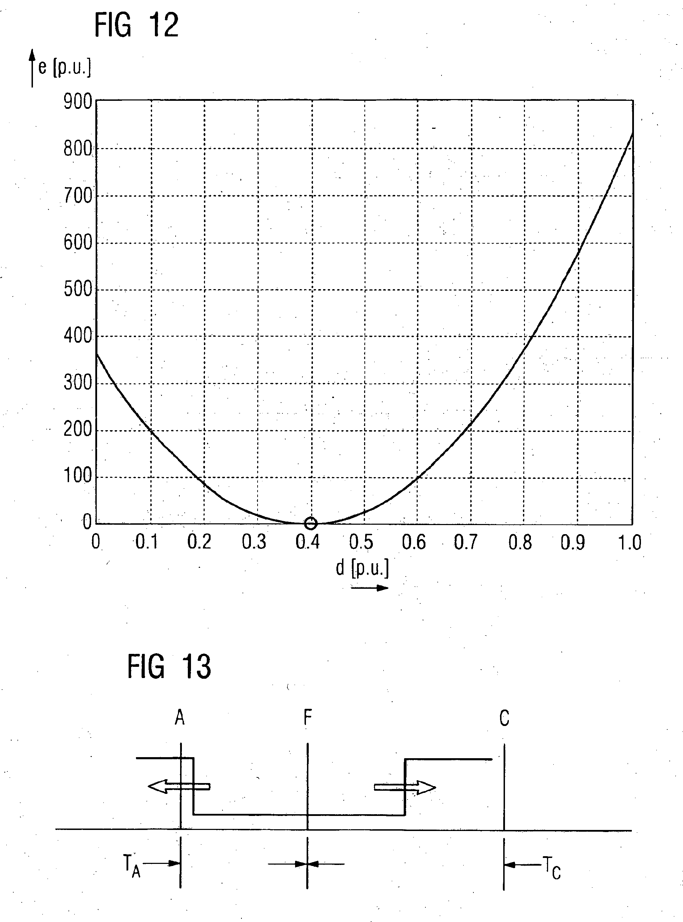

Zur Bestimmung des Datenfensterbeginns wird beispielsweise die Überschreitung eines U0-Schwellwertes als Startwert verwendet. Zur Synchronisation der Datenfenster von beiden Leitungsenden können zum Beispiel Vorfehlergrößen in Verbindung mit einem Nullsystem-Modell der gesunden Leitung verwendet werden. Alternativ kann die Zeitdifferenz der Datenfenster mit in die Lösung der nichtlinearen Optimierung einbezogen werden. Dazu werden die Laufzeiten der Welle von der Fehlerstelle bis zu den Messorten zum Beispiel wie folgt berücksichtigt (vgl. Figur 13): Mit Hilfe der Ausbreitungszeitkonstante der Telegraphengleichung kann die Entfernung der Messorte von der Fehlerstelle in eine Laufzeit der Welle von Fehlerort zu den Messorten umgerechnet werden:

$$T_A = \text{Im}\{\gamma\} \cdot l$$

$$T_C = \text{Im}\{\gamma\} \cdot (1-l)$$

Werden die Zeitpunkte des Eintreffens der Welle an den Messorten nun aus dem Anstiegsbeginn der Nullspannung exakt ermittelt, kann der Zeitversatz dieser Zeitpunkte gegenüber dem Fehlereintrittszeitpunkt an der Messstelle A durch TA und an der Messstelle C durch TC angegeben werden. Diese Zeitverschiebungen können nun wie folgt im Ansatz berücksichtigt werden:

$$e(l, j\omega, R', L', G', C') = \left(\text{Re}\{U_{0rA}\} - \text{Re}\{U_{0rC}\}\right)^2 + \left(\text{Im}\{U_{0rA}\} - \text{Im}\{U_{0rC}\}\right)^2$$

*mit*

$$U_{0rA} = k_{11}(j\omega,l) \cdot U_{0A} \cdot e^{-j\,\mathrm{Im}\{\gamma\}l} + k_{12}(j\omega,l) \cdot I_{0A} \cdot e^{-j\,\mathrm{Im}\{\gamma\}l}$$

$$U_{0rC} = k_{11}(j\omega,1-l) \cdot U_{0C} \cdot e^{-j\,\mathrm{Im}\{\gamma\}(1-l)} + k_{12}(j\omega,1-l) \cdot I_{0C} \cdot e^{-j\,\mathrm{Im}\{\gamma\}(1-l)}$$

Die Zeiger der auf den Datenfensterbeginn bezogenen komplexen Zeiger werden auf den Fehlereintrittszeitpunkt zurückgedreht.

Mittels Hochpassfilterung kann der Anteil der Grundschwingung eliminiert werden. Wird dieses Signal einer Effektivwertbildung unterzogen, entsteht ein der Hüllkurve des Einschwingvorgangs proportionales Signal. Aus diesem Signal kann mittels Koeffizientenvergleiches die Zeitkonstante der abklingenden e-Funktion ermittelt werden:

$$\tau = \frac{t_2 - t_1}{\ln\left(\dfrac{f(t_1)}{f(t_2)}\right)}$$

*mit:*

$$f(t_1) \quad \textit{Hüllkurve zum Zeitpunkt } t_1$$

$$f(t_2) \quad \textit{Hüllkurve zum Zeitpunkt } t_2$$

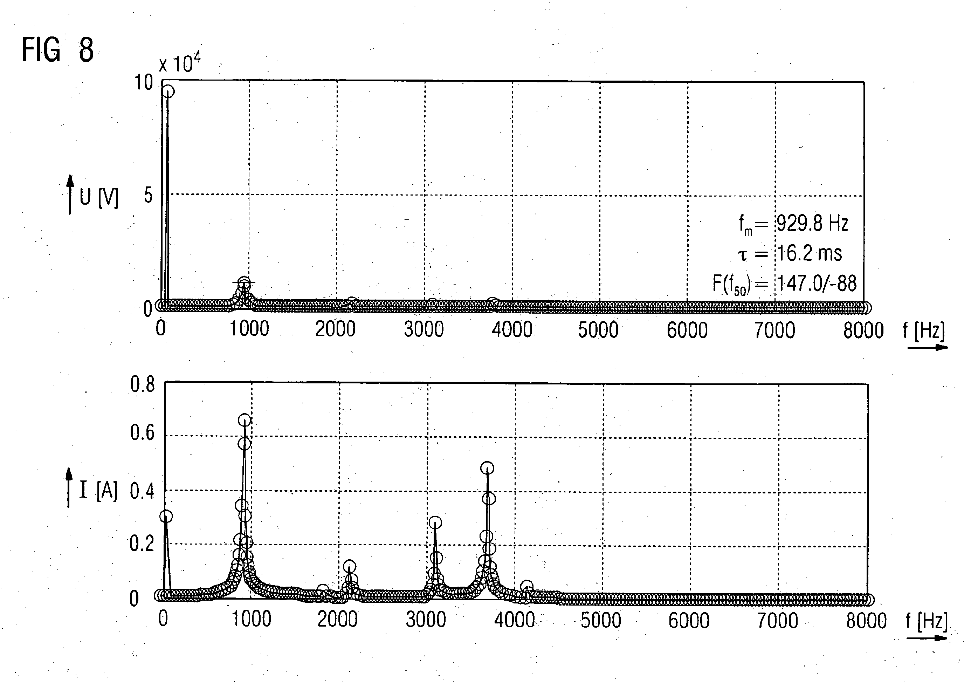

Die Figur 8 zeigt die mittels einer FFT (Fourier-Transformation) bestimmten Spektren von Nullstrom und Nullspannung. Aus dem Spektrum der Spannung wird im Bereich oberhalb der Nennfrequenz der Maximalwert gesucht.

Unter Ausnutzung der Symmetrie des Leakage-Effektes kann mittels linearer Interpolation die Mittenfrequenz aus den mittels FFT berechneten Abtastwerten des Spannungsspektrums ermittelt werden. Mit den nun bekannten Signalparametern Mittenfrequenz der dominanten Oberschwingung fm und der Abklingzeitkonstante der Hüllkurve lässt sich folgender Least-Squares-Schätzer für die Parameter eines wie folgt definierten Signalmodells aufstellen:

$$\delta = \begin{pmatrix} e^{-\frac{t_1}{\tau}} \cdot \sin(2\pi \cdot f_m \cdot t_1) & & e^{-\frac{t_N}{\tau}} \cdot \sin(2\pi \cdot f_m \cdot t_N) \\ e^{-\frac{t_1}{\tau}} \cdot \cos(2\pi \cdot f_m \cdot t_1) & & e^{-\frac{t_N}{\tau}} \cdot \cos(2\pi \cdot f_m \cdot t_N) \\ \sin(2\pi \cdot f_m \cdot t_1) & \cdots & \sin(2\pi \cdot f_m \cdot t_N) \\ \cos(2\pi \cdot f_m \cdot t_1) & & \cos(2\pi \cdot f_m \cdot t_N) \\ e^{-\frac{t_1}{\tau}} & & e^{-\frac{t_N}{\tau}} \end{pmatrix}$$

$$k = inv(\delta \cdot \delta^T) \cdot \delta$$

$$\Theta = k \cdot I_0$$

*mit*

$$I_0 = \begin{pmatrix} i_{0(1)} & \cdots & i_{0(N)} \end{pmatrix}$$

Der Schätzer berechnet ein Optimalfilter k. Für die Berechnung des komplexen Zeigers von Nullstrom oder Nullspannung reicht es aus, die ersten beiden Elemente des Parametervektors zu berechnen. Diese Elemente repräsentieren Real- und Imaginärteil des komplexen Zeigers der dominanten Ausgleichsschwingung.

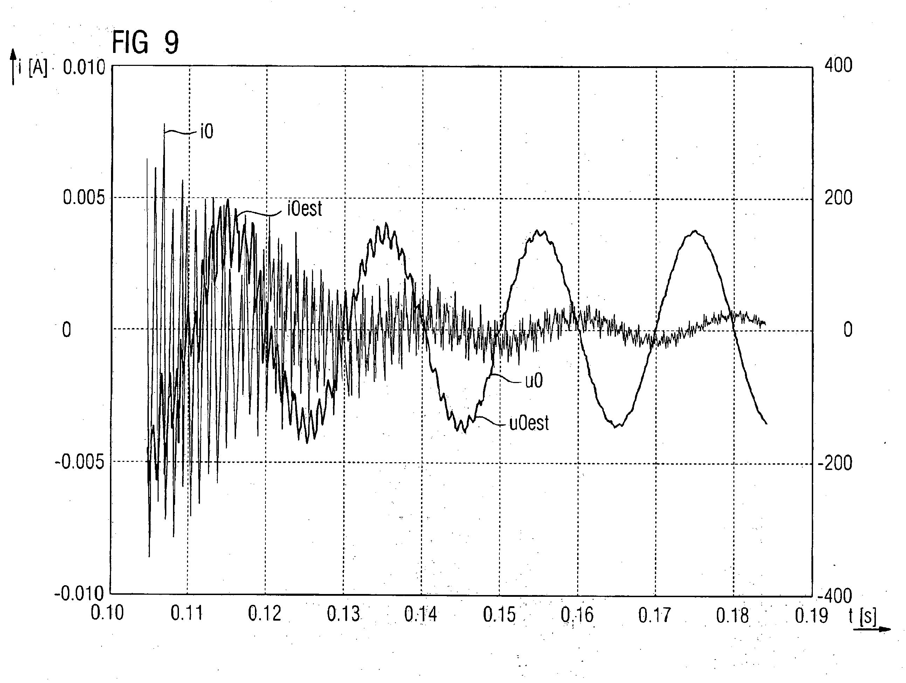

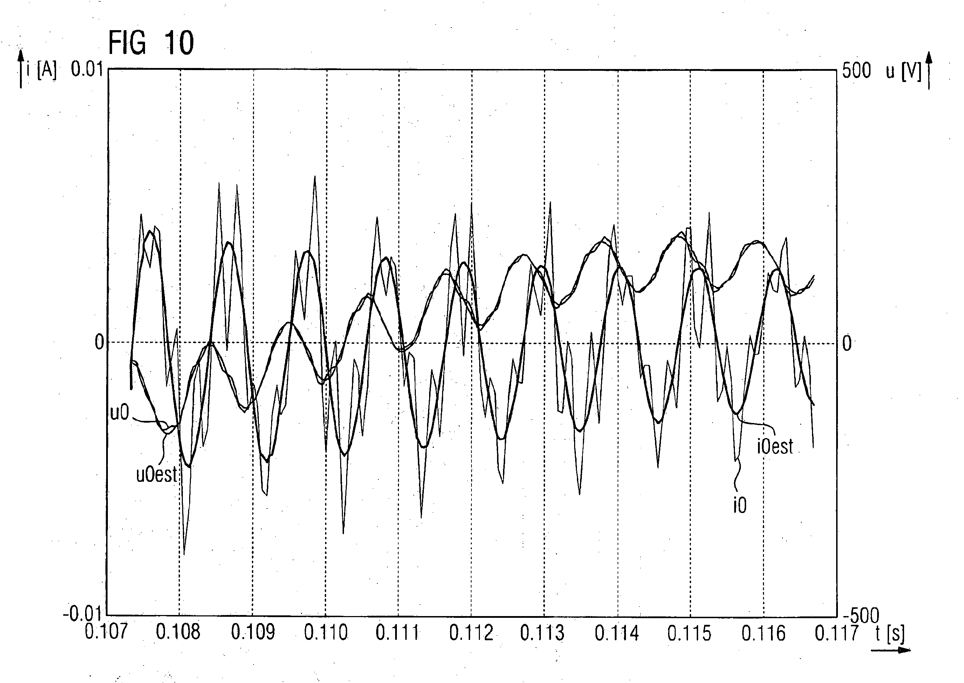

Die Figuren 9 und 10 zeigen die Approximation des gemessenen Signals von Nullspannung u0 und Nullstrom i0 durch das geschätzte Signal u0est und i0est (gebildet aus dem Signalmodell des Schätzers unter Verwendung der geschätzten Parameter) in jeweils anderer Zeitauflösung: Dabei zeigt die Figur 9 die Übereinstimmung von gemessenen und geschätzten Signalen im kompletten Datenfenster und die Figur 10 die Übereinstimmung von gemessenen und geschätzten Signalen im Ausschnitt.

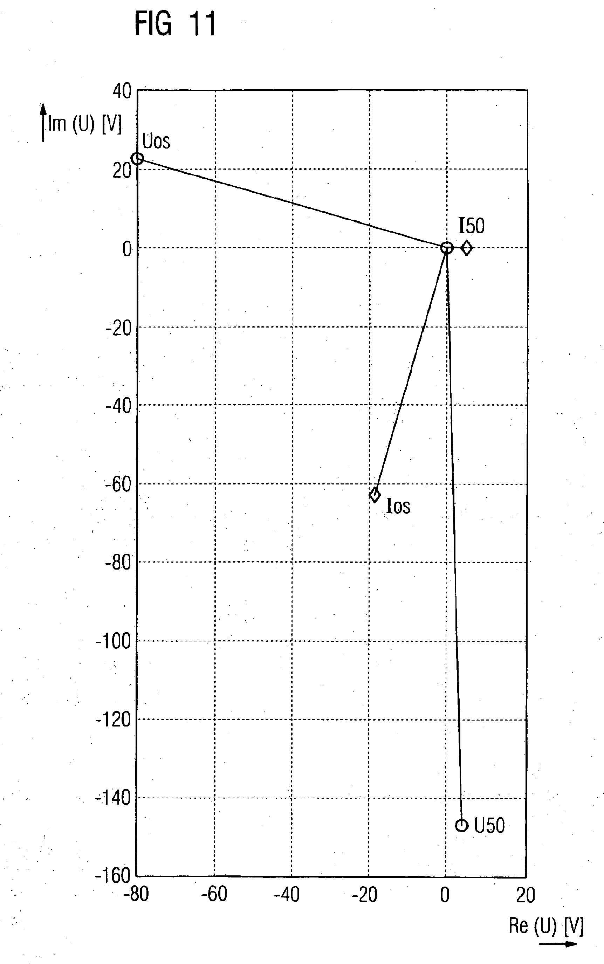

Die Figur 11 zeigt die aus den Parametern gebildeten komplexen Zeiger. In der Figur 11 sind deutlich die Größenverhältnisse zwischen den Grundwellenzeigern U50 und I50 und den Zeigern Uos und Ios der dominanten Frequenz fm des Einschwingvorgangs zu erkennen. Die Oberschwingungszeiger Uos und Ios gestatten eine wesentlich zuverlässigere Richtungsbestimmung und Fehlerortung, da der Betrag des Stromzeigers Ios deutlich größer als der Grundstromzeiger I50 ist.

Die Figur 12 zeigt beispielhaft die mit den Zeigern berechnete Kostenfunktion $e(d) = (\Delta Uf)^2$. Die Funktion zeigt die Differenz der mit den komplexen Zeigern der dominanten Einschwingfrequenz berechneten Spannung am Fehlerort. Für die dem Fehler entsprechende Fehlerentfernung stimmt die von beiden Seiten berechnete Fehlerspannung überein und die Kostenfunktion erreicht ihr Minimum. Das Minimum der Kostenfunktion kann beispielsweise mit Hilfe der Matlab-Funktion "fmin-search" berechnet werden. Dieser Funktion liegt der Simplex-Algorithmus zugrunde. Es lässt sich erkennen, dass die Fehlerentfernung bei d = 0,04 (d = 39,86 %) liegt.

Nachfolgend soll ein zweites Ausführungsbeispiel für eine Erdschlusserkennung näher beschrieben werden.

Das zweite Ausführungsbeispiel nutzt die bei einem Erdschluss entstehenden Einschwingvorgänge aus und berechnet die komplexen Zeiger für Nullstrom und Nullspannung für diesen Ein-schwingvorgang mit exponentiell abklingender Hüllkurve. Es wird dazu die in der Nullspannung vorhandene dominante Eigenfrequenz des Erdschluss-Einschwingvorgangs verwendet. Aus der Phasenlage dieser komplexen Zeiger von Nullstrom und Null-Spannung wird die Erdschlussrichtung ermittelt. Weiterhin werden die auf diese Weise ermittelten komplexen Zeiger über eine Kommunikationseinrichtung zum Schutzgerät übertragen, das das andere Ende der zu überwachenden Leitung schützt. Dazu kann eine IP-basierte Netzwerktechnik verwendet werden, die eine Verbindung zum anderen Umspannwerk nur bei Bedarf kurzzeitig aufbaut und nach einer definierten Zeit wieder beendet.

Die komplexen Zeiger der beiden Leitungsenden werden mittels Vorfehlerdaten oder mittels Erkennen des Eintrittszeitpunktes durch ein Signalmodell für die Signale im fehlerbehafteten Zustand auf eine gemeinsame Zeitbasis synchronisiert. Aus den komplexen Zeigern der Nullgrößen wird der prozentuale Abstand des Erdschlussorts von einem Leitungsende zum anderen durch Lösung der Maschengleichungen nach Figur 5 berechnet. Diese Lösung kann direkt oder unter Anwendung eines an sich bekannten Algorithmus zur nichtlinearen Optimierung erfolgen.

Die für die Lösung der Maschengleichungen erforderlichen Leitungsdaten des Nullsystems werden mit einem Schätzwert der Leitungsdaten ursprünglich eingestellt und bei einem außen liegenden Erdschluss automatisch gemessen und für spätere Anwendung gespeichert. Die Lösung der Maschengleichung des Nullsystems kann auch mit den 50Hz-Zeigern der Nullsystemgrößen durchgeführt werden.

In jedem Feldgerät wird bei einem Anstieg der Nullspannung über einen einstellbaren Schwellwert ein Triggersignal erzeugt, dass eine Aufzeichnung von Nullstrom und Nullspannung des an das Feldgerät angeschlossenen Abgangs auslöst. Von diesem Zeitpunkt an wird ein Datenfenster gewählt und mittels einer FFT das Signalspektrum der Nullspannung ermittelt.

Durch Bestimmung der Symmetrieachse des Maximalwertes der dominanten Oberschwingung im Spektrum wird die Frequenz der dominanten Oberschwingung bestimmt.

Durch Hochpassfilterung wird der Oberschwingungsanteil des Einschwingvorgangs von der Grundwelle getrennt und der Effektivwert des Oberschwingungsanteils bestimmt. Die Abklingzeitkonstante des Oberschwingungsanteils wird durch Koeffizientenvergleich oder mittels eines Least-Squares-Schätzverfahrens aus dem gefilterten Effektivwertsignal bestimmt.

Mit den nun bekannten Signalparametern Einschwingfrequenz und Abklingzeitkonstante der Hüllkurve wird mittels eines Least-Squares-Schätzers der komplexe Zeiger des Einschwingvorgangs berechnet.

Die Absolutzeit des Fehlereintrittes und der komplexe Zeiger des Einschwingvorgangs werden wechselseitig zum Gerät am anderen Leitungsende übertragen.

Bei gleicher Richtungsanzeige beider Leitungsenden wird der Fehlerort nach dem bereits im Zusammenhang mit den Figuren 1 bis 14 geschilderten Verfahren berechnet.

Bei unterschiedlicher Richtungsanzeige werden die Vierpolparameter des Nullsystems berechnet und für die Verwendung bei einem Erdschluss auf der eigenen Leitung gespeichert.

Durch die Ermittlung der komplexen Zeiger des Einschwingvorgangs kann die vom Erdschluss betroffene Leitung auch mit nicht speziell abgeglichenen Wandlern festgestellt werden. Es können also sehr geringe Anforderungen an die Messgenauigkeit der eingesetzten Wandler gestellt werden.

EP 2 260 556 B1

**Patentansprüche**

1. Verfahren zum Erzeugen eines Fehlersignals (F), das den Ort eines Erdschlusses auf einer Leitung (60) zwischen zwei Leitungsenden (A, C) kennzeichnet, wobei bei dem Verfahren an beiden Leitungsenden jeweils die Spannung und der Strom unter Bildung von Messwerten gemessen und nach oder bei einer Detektion eines Erdschlusses der Ort des Erdschlusses ermittelt wird,
**dadurch gekennzeichnet, dass**

   - mit den Messwerten der in der Nullspannung oder dem Nullstrom enthaltene Oberschwingungsanteil sowie dessen zeitliche Abklingkonstante ($\tau$) für jedes der beiden Leitungsenden ermittelt wird,
   - mit dem Oberschwingungsanteil und der Abklingkonstante für jedes Leitungsende jeweils eine Oberwellenzeigermessgröße (U0A, I0A, U0C, I0C) nach Betrag und Phase gebildet wird, wobei sich der zeitliche Bezugspunkt der Phase der Oberwellenzeigermessgröße auf den Zeitpunkt der Erdschlussdetektion an dem jeweiligen Leitungsende bezieht,
   - die in dieser Weise gebildeten Oberwellenzeigermessgrößen ausgehend von ihrem jeweiligen Leitungsende aus zeitlich in die Vergangenheit gedreht werden und ermittelt wird, zu welchem Zeitpunkt in der Vergangenheit und an welcher Stelle auf der Leitung die zurückgedrehten Oberwellenzeigermessgrößen zumindest annäherungsweise den gleichen Betrag und zumindest annäherungsweise die gleiche Phase aufweisen,
   - und der in dieser Weise ermittelte Ort als Ort des Erdschlusses angesehen und mit dem Fehlersignal ausgegeben wird.

2. Verfahren nach Anspruch 1,
**dadurch gekennzeichnet, dass**

   - unter Berücksichtigung der die Ausbreitung elektromagnetischer Wellen auf Leitungen beschreibenden Telegraphengleichung für einen wählbaren Ort auf der Leitung ein erster und ein zweiter Nullspannungszeiger für einen um die Ausbreitungszeit zum wählbaren Ort in der Vergangenheit liegenden Zeitpunkt unter Verwendung der Oberweilenzeigermeßgrößen von Nullstrom und Nullspannung an den beiden Leitungsenden berechnet werden, wobei der erste Nullspannungszeiger ausgehend von dem ersten Leitungsende in Richtung des zweiten Leitungsendes und der zweite Nullspannungszeiger ausgehend von dem zweiten Leitungsende in Richtung des ersten Leitungsendes berechnet wird,
   - die in dieser Weise berechneten beiden Nullspannungszeiger miteinander verglichen werden und derjenige Ort ausgewählt wird, an dem die berechneten Nullspannungszeiger am besten übereinstimmen, und
   - der in dieser Weise bestimmte Leitungsort als Ort des Erdschlusses angesehen wird.

3. Verfahren nach Anspruch 1 oder 2,
**dadurch gekennzeichnet, dass**

   - die beiden Oberwellenzeigermessgrößen nach Betrag und Phase jeweils unter Zugrundelegung eines vorgegebenen Signalmodells, das den zeitlichen Verlauf der Nullspannung im Falle eines Erdschlusses nachbildet, mittels eines Schätzverfahrens bestimmt werden,
   - wobei das vorgegebene Signalmodell zumindest die zu bestimmende Oberwellenzeigermessgröße mit einer festgelegten Zeigerkreisfrequenz, die ermittelte zeitliche Abklingkonstante des Oberschwingungsanteils und eine Nullspannungszeigermessgröße mit der Grundfrequenz der Nullspannung berücksichtigt und
   - wobei im Rahmen des Schätzverfahrens der Betrag und die Phase der Oberwellenzeigermessgröße derart angepasst werden, dass die Abweichung zwischen dem zeitlichen Signalverlauf des nachgebildeten Signals des Signalsmodells und dem gemessenen zeitlichen Signalverlauf der Messwerte der Nullspannung minimal ist.

4. Verfahren nach Anspruch 3,
**dadurch gekennzeichnet, dass**
als Schätzverfahren ein Least-Squares-Schätzverfahren, ein Kalman-Filter-Algorithmus oder ein ARMAX-Schätzverfahren verwendet wird.

5. Verfahren nach einem der voranstehenden Ansprüche, **dadurch gekennzeichnet, dass**

   - aus dem Frequenzspektrum des Oberschwingungsanteils eine für den Oberschwingungsanteil dominante Frequenz ausgewählt wird, und
   - die Zeigerkreisfrequenz der beiden Oberwellenzeigermessgrößen jeweils derart festgelegt wird, dass sie der dominanten Frequenz entspricht.

6. Verfahren nach einem der voranstehenden Ansprüche, **dadurch gekennzeichnet, dass**

   - in dem Oberschwingungsanteil diejenige Oberschwingungsfrequenz bestimmt wird, deren Amplitude maximal ist, und
   - die Zeigerkreisfrequenz der beiden Oberwellenzeigermessgrößen jeweils derart festgelegt wird, dass sie dieser Oberschwingungsfrequenz entspricht.

7. Verfahren nach einem der voranstehenden Ansprüche, **dadurch gekennzeichnet, dass**
   das Zeitfenster für die zur Bestimmung der Oberwellenzeigermessgrößen verwendeten Daten so bestimmt wird, dass der Zeitfensterbeginn auf den Beginn des Anstiegs der Nullspannung nach Überschreiten eines vorgegebenen Schwellenwertes festgelegt wird.

8. Verfahren nach einem der voranstehenden Ansprüche, **dadurch gekennzeichnet, dass** der Oberschwingungsanteil ermittelt wird, indem

   - nach der Detektion des Erdschlusses für jedes Leitungsende jeweils ein Messfenster geöffnet wird, für das mittels einer Fouriertransformation das Frequenzspektrum der Nullspannung ermittelt wird, und
   - das Frequenzspektrum einer Hochpassfilterung unterzogen wird, bei der die Oberwellen von der Grundfrequenz der Nullspannung unter Bildung des Oberschwingungsanteils getrennt werden.

9. Verfahren nach einem der voranstehenden Ansprüche, **dadurch gekennzeichnet, dass** die Abklingkonstante ermittelt wird, indem

   - der Effektivwert des Oberschwingungsanteils bestimmt wird und die zeitliche Abklingkonstante des Effektivwertes ermittelt wird und
   - die ermittelte zeitliche Abklingkonstante des Effektivwertes als zeitliche Abklingkonstante des Oberschwingungsanteils angesehen wird.

10. Verfahren nach einem der voranstehenden Ansprüche, **dadurch gekennzeichnet, dass**
    das Messen der Spannung an den beiden Leitungsenden synchronisationsfrei erfolgt und die Spannungsmesswerte an den beiden Leitungsenden unsynchronisiert sind.

11. Anordnung zum Erzeugen eines Fehlersignals, das den Ort eines Erdschlusses auf einer Leitung (60) zwischen einem ersten und einem zweiten Leitungsende (A, C) kennzeichnet, wobei die Anordnung aufweist:

    - ein erstes Messgerät (40) an dem ersten Leitungsende (A) der Leitung,
    - ein zweites Messgerät (42) an dem zweiten Leitungsende © der Leitung und
    - eine mit den beiden Messgeräten verbundene Auswerteinrichtung (200), die geeignet ist, mit den Messwerten der beiden Messgeräte ein Verfahren nach einem der voranstehenden Ansprüche 1-10 auszuführen.

12. Anordnung nach Anspruch 11,
    **dadurch gekennzeichnet, dass**
    die Auswerteinrichtung durch eine programmierte Datenverarbeitungsanlage gebildet ist.

13. Anordnung nach Anspruch 11 oder 12,
    **dadurch gekennzeichnet, dass**
    die Auswerteinrichtung in einer Zentraleinrichtung angeordnet ist, mit der die beiden Messgeräte in Verbindung stehen.

14. Anordnung nach Anspruch 11 oder 12,
    **dadurch gekennzeichnet, dass**

    - die beiden Messgeräte miteinander verbunden sind und
    - die Auswerteinrichtung in einem der Messgeräte implementiert ist.

15. Feldgerät (42), insbesondere Schutzgerät, zum Anschluss an ein Leitungsende (C) einer elektrischen Leitung (60) und zum Erkennen eines Erdschlusses auf der Leitung mit

- einer Auswerteinrichtung (200), die geeignet ist, ein Verfahren nach einem der voranstehenden Ansprüche 1-10 auszuführen und
- einem Datenanschluss (D42) zum Anschluss an ein anderes Messgerät (40) zum Empfangen von Messwerten (U0A, IOA), die sich auf das andere Leitungsende der Leitung beziehen.

**Claims**

1. Method for producing a fault signal (F) which identifies the location of a ground fault on a line (60) between two line ends (A, C) wherein, in the method, the voltage and the current are measured at each of the two line ends, with measured values being formed, and, after or on detection of a ground fault, the location of the ground fault is determined,
   **characterized in that**

   - the harmonic component contained in the zero phase-sequence voltage or the zero phase-sequence current, as well as its decay time constant ($\tau$) is determined for each of the two line ends, using the measured values,
   - the magnitude and phase of a harmonic vector measurement variable (U0A, I0A, U0C, I0C) are in each case formed using the harmonic component and the decay constant for each line end, wherein the time reference point of the phase of the harmonic vector measurement variable relates to the time of the ground fault detection at the respective line end,
   - the harmonic vector measurement variables formed in this way are rotated, starting from their respective line end, to a time in the past, and the time in the past and the point on the line at which the rotated-back harmonic vector measurement variables have at least approximately the same magnitude and at least approximately the same phase are determined,
   - and the location determined in this way is regarded as the location of the ground fault, and is output with the fault signal.

2. Method according to Claim 1,
   **characterized in that**

   - taking account of the telegraph equation, which describes the propagation of electromagnetic waves on lines, a first and a second zero phase-sequence voltage vector are calculated for a selectable point on the line, for a time which is located in the past corresponding to the propagation time to the selectable location, using the harmonic vector measurement variables of zero phase-sequence current and zero phase-sequence voltage at the two line ends, wherein the first zero phase-sequence voltage vector is calculated starting from the first line end in the direction of the second line end, and the second zero phase-sequence voltage vector is calculated starting from the second line end in the direction of the first line end,
   - the two zero phase-sequence voltage vectors calculated in this way are compared with one another, and that location is selected at which the calculated zero phase-sequence voltage vectors best match, and
   - the line location determined in this way is regarded as the location of the ground fault.

3. Method according to Claim 1 or 2,
   **characterized in that**

   - the magnitude and phase of the two harmonic vector measurement variables are in each case determined by means of an estimation method on the basis of a predetermined signal model, which models the time profile of the zero phase-sequence voltage in the case of a ground fault,
   - wherein the predetermined signal model takes account at least of the harmonic vector measurement variable to be determined at a defined vector angular frequency, the determined decay time constant of the harmonic component and a zero phase-sequence voltage vector measurement variable at the fundamental frequency of the zero phase-sequence voltage, and
   - wherein, during the course of the estimation method, the magnitude and the phase of the harmonic vector measurement variable are adapted such that the discrepancy between the time signal profile of the modeled signal of the signal model and the measured time signal profile of the measured values of the zero phase-sequence voltage is a minimum.

**4.** Method according to Claim 3, **characterized in that** a least squares estimation method, a Kalman filter algorithm or an ARMAX estimation method is used as the estimation method.

**5.** Method according to one of the preceding claims, **characterized in that**

- a frequency which is dominant for the harmonic component is selected from the frequency spectrum of the harmonic component, and
- the vector angular frequency of the two harmonic vector measurement variables is in each case defined such that it corresponds to the dominant frequency.

**6.** Method according to one of the preceding claims, **characterized in that**

- that harmonic frequency whose amplitude is a maximum is determined in the harmonic component, and
- the vector angular frequency of the two harmonic vector measurement variables is in each case defined such that it corresponds to this harmonic frequency.

**7.** Method according to one of the preceding claims, **characterized in that** the time window for the data used to determine the harmonic vector measurement variables is determined such that the time window start is fixed at the start of the rise of the zero phase-sequence voltage after a predetermined threshold value has been exceeded.

**8.** Method according to one of the preceding claims, **characterized in that** the harmonic component is determined **in that**

- a measurement window for which the frequency spectrum of the zero phase-sequence voltage is determined by means of a Fourier transformation is in each case opened for each line end after the detection of the ground fault, and
- the frequency spectrum is subjected to high-pass filtering, in which the harmonics of the fundamental frequency of the zero phase-sequence voltage are separated, forming the harmonic component.

**9.** Method according to one of the preceding claims, **characterized in that** the decay constant is determined **in that**

- the root mean square value of the harmonic component is determined and the decay time constant of the root mean square value is determined, and
- the determined decay time constant of the root mean square value is regarded as the decay time constant of the harmonic component.

**10.** Method according to one of the preceding claims, **characterized in that** the measurement of the voltage at the two line ends is carried out free of synchronization, and the voltage measured values at the two line ends are unsynchronized.

**11.** Arrangement for producing a fault signal, which identifies the location of a ground fault on a line (60) between a first and a second line end (A, C), wherein the arrangement has:

- a first measurement instrument (40) at the first line end (A) of the line,
- a second measurement instrument (42) at the second line end (C) of the line, and
- an evaluation device (200), which is connected to the two measurement instruments and is suitable for using the measured values from the two measurement instruments to carry out a method according to one of the preceding Claims 1-10.

**12.** Arrangement according to Claim 11, **characterized in that** the evaluation device is formed by a programmed data processing installation.

**13.** Arrangement according to Claim 11 or 12, **characterized in that** the evaluation device is arranged in a central device to which the two measurement instruments are connected.

**14.** Arrangement according to Claim 11 or 12,
**characterized in that**

- the two measurement instruments are connected to one another and
- the evaluation device is implemented in one of the measurement instruments.

**15.** Field device (42), in particular a protective device, for connection to one line end (C) of an electrical line (60) and for identification of a ground fault on the line, having

- an evaluation device (200) which is suitable for carrying out a method according to one of the preceding Claims 1-10, and
- a data connection (D42) for connection to another measurement instrument (40) for receiving measured values (U0A, I0A) which relate to the other line end of the line.

**Revendications**

**1.** Procédé de production d'un signal (F) d'erreur, qui caractérise l'emplacement d'une mise à la terre sur une ligne (60) entre deux extrémités (A, C) de la ligne, dans lequel, dans le procédé, on mesure aux deux extrémités de la ligne respectivement la tension et le courant en formant des valeurs de mesure et, après ou lors d'une détection d'une mise à la terre, on détermine l'emplacement de la mise à la terre, **caractérisé en ce que**

- on détermine pour chacune des deux extrémités de la ligne, par les valeurs de mesure, la teneur en harmonique contenue dans la tension nulle ou dans le courant nul ainsi que sa constante (•) de décroissance dans le temps,
- on forme en valeur absolue et en phase, par la teneur en harmonique et par la constante de décroissance, pour chaque extrémité de la ligne respectivement une grandeur (UOA, IOA, UOC, IOC) de mesure de vecteur d'harmonique, le point de référence dans le temps de la phase de la grandeur de mesure du vecteur d'harmonique se rapportant à l'instant de la détection de mise à la terre sur l'extrémité respective de la ligne,
- on fait tourner dans le passé les grandeurs de mesure de vecteur d'harmonique ainsi formées à partir de leur extrémité respective de la ligne et on détermine à quel instant dans le passé et en quel endroit de la ligne les grandeurs de mesure de vecteur d'harmonique, qui ont été tournées en arrière, ont au moins à peu près la même valeur absolue et au moins à peu près la même phase,
- et on considère l'emplacement ainsi déterminé comme étant l'emplacement de la mise à la terre et on le donne par le signal d'erreur.

**2.** Procédé suivant la revendication 1,
**caractérisé en ce que**

- en tenant compte de l'équation télégraphique décrivant la propagation d'ondes électromagnétiques sur des lignes, on calcule, pour un emplacement pouvant être sélectionné sur la ligne, un premier et un deuxième vecteurs de tension nulle pour un instant se trouvant dans le passé du temps de propagation vers l'emplacement pouvant être sélectionné, en utilisant les grandeurs de mesure de vecteur d'harmonique de courant nul et de tension nulle aux deux extrémités de la ligne, le premier vecteur de tension nulle étant calculé à partir de la première extrémité de la ligne en direction de la deuxième extrémité de la ligne et le deuxième vecteur de tension nulle à partir de la deuxième extrémité de la ligne en direction de la première extrémité de la ligne,
- on compare entre eux les deux vecteurs de tension ainsi calculés et on sélectionne l'emplacement où les vecteurs de tension nulle calculés coïncident au mieux et
- on considère l'emplacement de la ligne ainsi déterminé comme l'emplacement de la mise à la terre.

**3.** Procédé suivant la revendication 1 ou 2,
**caractérisé en ce que**

- on détermine au moyen d'un procédé d'estimation les deux grandeurs de mesure de vecteur d'harmonique en valeur absolue et en phase respectivement sur la base d'un modèle de signal donné à l'avance, qui reproduit la courbe dans le temps de la tension nulle dans le cas d'une mise à la terre,
- dans lequel le modèle de signal donné à l'avance prend en compte au moins la grandeur de mesure de vecteur d'harmonique à déterminer ayant une pulsation vectorielle fixée, la constance de décroissance dans le temps déterminée de la teneur en harmonique et une grandeur de mesure de vecteur de tension nulle ayant la fréquence fondamentale de la tension nulle et

- dans lequel, dans le cadre du procédé d'estimation, on adapte la valeur absolue et la phase de la grandeur de mesure de vecteur d'harmonique de manière à minimiser l'écart entre la courbe du signal dans le temps du signal reproduit du modèle de signal et la courbe de signal dans le temps mesurée des valeurs de mesure de la tension nulle.

**4.** Procédé suivant la revendication 3,
**caractérisé en ce que**
l'on utilise comme procédé d'estimation un procédé d'estimation par les moindres carrés, un algorithme de filtre Kalman ou un procédé d'estimation Armax.

**5.** Procédé suivant l'une des revendications précédentes, **caractérisé en ce que**

- on sélectionne dans le spectre de fréquence de la teneur en harmonique une fréquence prépondérante pour la teneur en harmonique et
- on fixe la pulsation vectorielle des deux grandeurs de mesure de vecteur d'harmonique respectivement de manière à ce qu'elles correspondent à la fréquence prépondérante.

**6.** Procédé suivant l'une des revendications précédentes,
**caractérisé en ce que**

- on détermine dans la teneur en harmonique la fréquence d'harmonique dont l'amplitude est maximum et
- on fixe la pulsation vectorielle des deux grandeurs de mesure de vecteur d'harmonique respectivement de manière à ce qu'elles correspondent à cette fréquence d'harmonique.

**7.** Procédé suivant l'une des revendications précédentes,
**caractérisé en ce que**
l'on détermine le créneau temporel pour les données utilisées pour la détermination des grandeurs de mesure de vecteur d'harmonique de manière à ce que le début du créneau temporel soit fixé au début de l'élévation de la tension nulle après dépassement d'une valeur de seuil donnée à l'avance.

**8.** Procédé suivant l'une des revendications précédentes,
**caractérisé en ce que**
l'on détermine la teneur en harmonique

- en ouvrant après la détection de la mise à la terre pour chaque extrémité de la ligne respectivement un créneau de mesure, pendant lequel on détermine au moyen d'une transformation de Fourrier le spectre de fréquence de la tension nulle et
- en soumettant le spectre de fréquence à un filtrage passe haut dans lequel les harmoniques sont séparés avec la formation de la teneur en harmonique, de la fréquence fondamentale de la tension nulle.

**9.** Procédé suivant l'une des revendications précédentes,
**caractérisé en ce que**
l'on détermine la constante de décroissance

- en définissant la valeur efficace de la teneur en harmonique et en déterminant la constante de décroissance dans le temps de la valeur efficace et
- en considérant la constante de décroissance dans le temps déterminée de la valeur efficace comme la constante de décroissance dans le temps de la teneur en harmonique.

**10.** Procédé suivant l'une des revendications précédentes,
**caractérisé en ce que**
la mesure de la tension aux deux extrémités de la ligne s'effectue sans synchronisation et les valeurs de mesure de la tension aux deux extrémités de la ligne ne sont pas synchronisées.

**11.** Agencement de production d'un signal d'erreur, qui caractérise l'emplacement d'une mise à la terre sur une ligne (60) entre une première et une deuxième extrémités (A, C) de la ligne, dans lequel l'agencement comporte :

- un premier appareil (40) de mesure à la première extrémité (A) de la ligne,
- un deuxième appareil (42) de mesure à la deuxième extrémité et
- un dispositif (200) d'exploitation, qui est relié aux deux appareils de mesure et qui est propre à effectuer avec les valeurs de mesure des deux appareils de mesure un procédé suivant l'une des revendications précédentes 1 à 10.

12. Agencement suivant la revendication 11,
**caractérisé en ce que**
le dispositif d'exploitation est formé par une installation programmée de traitement de données.

13. Agencement suivant la revendication 11 ou 12,
**caractérisé en ce que**
le dispositif d'exploitation est disposé dans un dispositif central avec lequel les deux appareils de mesure sont en liaison.

14. Agencement suivant la revendication 11 ou 12,
**caractérisé en ce que**

- les deux appareils de mesure sont reliés l'un à l'autre et
- le dispositif d'exploitation est mis en oeuvre dans l'un des appareils de mesure.

15. Appareil (42) de terrain, notamment appareil de protection pour le raccordement à une extrémité (C) d'une ligne (60) électrique et pour reconnaître une mise à la terre sur la ligne, comprenant

- un dispositif (200) d'exploitation qui est propre à effectuer un procédé suivant l'une des revendications précédentes 1 à 10,
- une borne (D42) de données de raccordement à un autre appareil (40) de mesure pour la réception de valeurs (UOA, IOA) de mesure, qui se rapportent à l'autre extrémité de la ligne.

FIG 1

EP 2 260 556 B1

## FIG 2

## FIG 3

FIG 4

FIG 5

## FIG 6

**FIG 7**

EP 2 260 556 B1

FIG 8

$f_m = 929.8$ Hz
$\tau = 16.2$ ms
$F(f_{50}) = 147.0/-88$

FIG 9

EP 2 260 556 B1

FIG 10

EP 2 260 556 B1

# FIG 11

## FIG 12

## FIG 13

FIG 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0933643 A1

**In der Beschreibung aufgeführte Nicht-Patentliteratur**

- A Fast Algorithm For Fast Nonlinearly Constrained Optimization Calculations. Lecture Notes in Mathematics. Springer Verlag, 1978, vol. 630